# EUROPÄISCHE PATENTSCHRIFT

(11) **EP 2 193 561 B1**
(45) Veröffentlichungstag und Bekanntmachung des Hinweises auf die Patenterteilung: **04.06.2014**
(21) Anmeldenummer: 08801126.7
(22) Anmeldetag: 06.08.2008
(51) Int. Cl.: H01L 51/52

(54) **OPTOELEKTRONISCHES BAUTEIL**
OPTOELECTRONIC COMPONENT
COMPOSANT OPTOÉLECTRONIQUE

(30) Priorität: 26.09.2007 DE 102007046028; 24.10.2007 DE 102007050876
(43) Veröffentlichungstag der Anmeldung: 09.06.2010
(73) Patentinhaber: OSRAM Opto Semiconductors GmbH, 93055 Regensburg (DE)
(72) Erfinder: SCHINDLER, Florian, 83278 Traunstein (DE); KRUMMACHER, Benjamin Claus, 93057 Regensburg (DE); VON MALM, Norwin, 93152 Nittendorf (DE); BERBEN, Dirk, 86399 Bobingen (DE); JERMANN, Frank, 86343 Königsbrunn (DE); ZACHAU, Martin, 82269 Geltendorf (DE)
(74) Vertreter: Epping - Hermann - Fischer
(86) Internationale Anmeldenummer: PCT/DE2008/001292
(87) Internationale Veröffentlichungsnummer: WO 2009/039803

(56) Entgegenhaltungen:
- WO-A-2007/036214
- US-A1- 2006 158 403

## Beschreibung

Die vorliegende Erfindung betrifft ein organisches optoelektronisches Bauteil, das im Betrieb elektromagnetische Strahlung emittieren kann.

Die Druckschrift WO 2007/036214 A beschreibt ein optoelektronisches Bauteil mit einem anorganischen Halbleiterchip.

Die Druckschrift US 2006/158403 A1 beschreibt ein Bauteil gemäß dem Oberbegriff des Patentanspruch 1.

Zumindest eine Aufgabe von bestimmten Ausführungsformen der vorliegenden Erfindung ist es, ein optoelektronisches Bauteil mit einem Wellenlängenkonversionsbereich anzugeben, das im Betrieb elektromagnetische Strahlung mit einer erhöhten Effizienz emittieren kann.

Diese Aufgabe wird durch den Gegenstand mit den Merkmalen des unabhängigen Patentanspruchs gelöst. Vorteilhafte Ausführungsformen und Weiterbildungen des Gegenstands sind in den abhängigen Ansprüchen gekennzeichnet und gehen aus der nachfolgenden Beschreibung und den Zeichnungen hervor.

Ein optoelektronisches Bauteil gemäß einer Ausführungsform der Erfindung umfasst insbesondere eine organische Schichtenfolge auf einem Trägersubstrat, die im Betrieb eine elektromagnetische Strahlung mit einem ersten Spektrum abstrahlt sowie eine dielektrische Schichtenfolge und einen Wellenlängenkonversionsbereich im Strahlengang der von der organischen Schichtenfolge abgestrahlten elektromagnetischen Strahlung. Der Wellenlängenkonversionsbereich ist eingerichtet, zumindest teilweise elektromagnetische Strahlung mit dem ersten Wellenlängenspektrum in eine elektromagnetische Strahlung mit einem zweiten Wellenlängenspektrum umzuwandeln. Die dielektrische Schichtenfolge ist im Strahlengang der von der organischen Schichtenfolge abgestrahlten elektromagnetischen Strahlung zwischen der organischen Schichtenfolge und dem Wellenlängenkonversionsbereich angeordnet und für eine elektromagnetische Strahlung mit einem dritten Wellenlängenspektrum, das zumindest einem Teil des zweiten Wellenlängenspektrums entspricht wenigstens teilweise undurchlässig.

Das Bauteil ist dadurch gekennzeichnet, dass die dielektrische Schichtenfolge eine Verkapselung für die organische Schichtenfolge bildet, die dielektrische Schichtenfolge die organische Schichtenfolge auf den Teilen ihrer Oberfläche, die nicht vom Trägersubstrat bedeckt sind, bedeckt, und die dielektrische Schichtenfolge einen Schutz der organischen Schichtenfolge vor Feuchtigkeit und atmosphärischen Gasen bildet.

Insbesondere kann dabei von einem Betrachter im Betrieb des optoelektronischen Bauteils eine emittierte elektromagnetische Strahlung wahrgenommen werden. Diese kann im Wesentlichen einer Überlagerung der elektromagnetischen Strahlung mit dem ersten Spektrum, welche durch den Wellenlängenkonversionsbereich ohne Wellenlängenkonversion abgestrahlt wird, und der elektromagnetischen Strahlung mit dem zweiten Wellenlängenspektrum, welche von dem Wellenlängenkonversionsbereich abgestrahlt wird, entsprechen.

Dabei wird im Betrieb des optoelektronischen Bauteils die elektromagnetische Strahlung mit dem ersten Wellenlängenspektrum von der organischen Schichtenfolge abgestrahlt und trifft nach einem Durchtreten der dielektrischen Schichtenfolge auf den Wellenlängenkonversionsbereich. Die elektromagnetische Strahlung mit dem ersten Wellenlängenspektrum wird zumindest teilweise in elektromagnetische Strahlung mit dem zweiten Wellenlängenspektrum umgewandelt. Ein Abstrahlen der elektromagnetischen Strahlung mit dem zweiten Wellenlängenspektrum erfolgt üblicherweise isotrop, also in verschiedenen Richtungen. Anders ausgedrückt wird ein Teil der elektromagnetischen Strahlung mit dem zweiten Wellenlängenspektrum in Richtung der organischen Schichtenfolge und der dielektrischen Schichtenfolge, also entgegen dem Strahlengang der elektromagnetischen Strahlung mit dem ersten Wellenlängenspektrum, abgestrahlt.

Da die dielektrische Schichtenfolge undurchlässig für elektromagnetische Strahlung mit dem dritten Wellenlängenspektrum ist, das zumindest einem Teil des zweiten Wellenlängenspektrums entspricht, kann die konvertierte elektromagnetische Strahlung mit dem zweiten Spektrum den Bereich der organischen Schichtenfolge nicht erreichen. Somit kann verhindert werden, dass die elektromagnetische Strahlung mit dem zweiten Wellenlängenspektrum in der organischen Schichtenfolge energetisch absorbiert wird. Durch die geringere beziehungsweise verhinderte Absorption in der organischen Schichtenfolge kann die Effizienz des optoelektronischen Bauteils erhöht werden.

Bei einer Ausführungsform der Erfindung bezeichnet "Wellenlängenspektrum" oder "Spektrum" oder "Teilspektrum" eine spektrale Verteilung von elektromagnetischer Strahlung mit mindestens einer spektralen Komponente mit einer Wellenlänge oder einer Mehrzahl von spektralen Komponenten mit mehreren Wellenlängen und/oder Bereichen von Wellenlängen. Ein erstes Spektrum und ein zweites Spektrum sind im Folgenden gleich, wenn die spektralen Komponenten und deren relativen Intensitäten gleich im Falle des ersten und des zweiten Spektrums sind, wobei die absolute Intensität des ersten Spektrums von der absoluten Intensität des zweiten Spektrums abweichen kann.

Bei einer Ausführungsform der Erfindung bezeichnet "teilweise" ein Teilspektrum eines Spektrums, beispielsweise des ersten Spektrums. Insbesondere kann das Teilspektrum eines Spektrums aus einem Teil der spektralen Komponenten dieses Spektrums bestehen. Weiterhin kann "teilweise" auch einen Teil einer Intensität eines Spektrums oder Teilspektrums bezeichnen.

Bei einer weiteren Ausführungsform der Erfindung kann "umwandeln" bedeuten, dass das Teilspektrum der elektromagnetischen Strahlung mit dem ersten Spektrum, die von dem Wellenlängenkonversionsbereich zumindest teilweise in elektromagnetische Strahlung mit dem zweiten Spektrum umgewandelt wird, und das zweite Spektrum nicht gleich sind. Das kann insbesondere bedeuten, dass das zweite Spektrum eine spektrale Verteilung aufweist, die von der spektralen Verteilung des Teilspektrums der elektromagnetischen Strahlung mit dem ersten Spektrum verschieden ist.

Weiterhin kann ein Wellenlängenkonversionsbereich ein Absorptionsspektrum und ein Emissionsspektrum aufweisen, wobei das Absorptionsspektrum und das Emissionsspektrum vorteilhafterweise nicht gleich sind. Vorzugsweise umfasst das Absorptionsspektrum dabei das Teilspektrum der elektromagnetischen Strahlung mit dem ersten Spektrum und das Emissionsspektrum das zweite Spektrum. Insbesondere können das Absorptionsspektrum und das Emissionsspektrum jeweils weitere spektrale Komponenten umfassen, die nicht im Teilspektrum der elektromagnetischen Strahlung mit dem ersten Spektrum beziehungsweise dem zweiten Spektrum enthalten sind. Es wird also in dem Wellenlängenkonversionsbereich aus elektromagnetischer Strahlung mit dem ersten Wellenlängenspektrum eine elektromagnetische Strahlung mit dem zweiten Wellenlängenspektrum erzeugt.

Die dielektrische Schichtenfolge ist für die elektromagnetische Strahlung mit dem ersten Wellenlängenspektrum vorzugsweise zumindest teilweise transparent. Dabei kann eine Transparenz der dielektrischen Schichtenfolge für die elektromagnetische Strahlung mit dem ersten Wellenlängenspektrum von einem jeweiligen Einfallswinkel abhängig sein. Beispielsweise ist die dielektrische Schichtenfolge für senkrecht einfallende elektromagnetische Strahlung mit dem ersten Wellenlängenspektrum transparent oder zumindest teilweise durchlässig, während sie für elektromagnetische Strahlung mit dem ersten Wellenlängenspektrum, die unter einem bestimmten flacheren Winkel eintrifft, zumindest teilweise undurchlässig ist.

Das erste Wellenlängenspektrum umfasst beispielsweise einen blauen und/oder einen grünen Wellenlängenbereich, während das zweite Wellenlängenspektrum einen gelben Wellenlängenbereich umfasst. Das dritte Wellenlängenspektrum, das zumindest einem Teil des zweiten Wellenlängenspektrums entspricht, kann daher ebenfalls einen gelben Wellenlängenbereich umfassen.

In einer Ausführungsform reflektiert die dielektrische Schichtenfolge die elektromagnetische Strahlung mit dem dritten Wellenlängenspektrum zumindest überwiegend. Dementsprechend kann beispielsweise die elektromagnetische Strahlung mit dem ersten Spektrum im Wesentlichen ungehindert von der organischen Schichtenfolge durch die dielektrische Schichtenfolge in den Wellenlängenkonversionsbereich durchtreten, während elektromagnetische Strahlung mit dem zweiten beziehungsweise dritten Wellenlängenspektrum, die in dem Wellenlängenkonversionsbereich abgestrahlt beziehungsweise erzeugt wird, von der dielektrischen Schichtenfolge nach außen, also in einer Abstrahlrichtung des optoelektronischen Bauteils reflektiert wird.

In einer weiteren Ausführungsform weist die dielektrische Schichtenfolge wenigstens zwei Schichten mit unterschiedlicher Dielektrizitätskonstante auf. Beispielsweise weisen hierbei benachbarte Schichten der wenigstens zwei Schichten unterschiedliche Brechungsindices auf. Durch den Brechungsindexsprung zwischen den benachbarten Schichten kann es zu einer wellenlängenabhängigen Transmission beziehungsweise Reflexion von elektromagnetischer Strahlung kommen.

Beispielsweise weist die dielektrische Schichtenfolge eine Grenzwellenlänge auf, wobei die dielektrische Schichtenfolge für elektromagnetische Strahlung mit einer Wellenlänge kleiner als die Grenzwellenlänge im Wesentlichen durchlässig und für elektromagnetische Strahlung mit einer Wellenlänge größer als die Grenzwellenlänge im Wesentlichen undurchlässig ist. Die Grenzwellenlänge hängt dabei beispielsweise von den verwendeten Brechungsindices der Schichten der dielektrischen Schichtenfolge und/oder von jeweiligen Schichtdicken der entsprechenden Schichten ab. Dabei können insbesondere Interferenzeffekte der die dielektrische Schichtenfolge durchtretenden elektromagnetischen Strahlung auftreten. Die dielektrische Schichtenfolge kann beispielsweise nach Art eines Bragg-Spiegel ausgebildet sein oder ein Bragg-Spiegel sein.

Eine Transmission beziehungsweise eine Reflexion von elektromagnetischer Strahlung an der dielektrischen Schichtenfolge erfolgt verlustfrei, so dass es zu keiner Absorption von elektromagnetischer Strahlung kommt. Dadurch kann vorteilhafterweise eine Erwärmung des optoelektronischen Bauteils im Betrieb verringert werden.

In verschiedenen Ausführungsformen ist die dielektrische Schichtenfolge als Dünnschichtstapel ausgeführt. Vorzugsweise weisen die jeweiligen Schichten eine Dicke kleiner als 100 nm auf.

In verschiedenen Ausführungsformen können die dielektrische Schichtenfolge und der Wellenlängenkonversionsbereich in mittelbaren oder unmittelbaren Kontakt mit der organischen Schichtenfolge stehen. Beispielsweise ist die dielektrische Schichtenfolge direkt oder über zusätzliche Zwischenschichten mit der organischen Schichtenfolge verbunden.

Die dielektrische Schichtenfolge bildet eine Verkapselung für die organische Schichtenfolge. Das heißt, neben ihren optischen Eigenschaften bildet die dielektrische Schichtenfolge einen Schutz der organischen Schichtenfolge vor Feuchtigkeit und atmosphärischen Gasen. Die dielektrische Schichtenfolge bedeckt dabei auch Seitenflächen der organischen Schichtenfolge. Die organische Schichtenfolge ist auf ein Substrat aufgebracht. Die dielektrische Schichtenfolge bedeckt die organische Schichtenfolge dann auf den Teilen ihrer Oberfläche, die nicht vom Substrat bedeckt sind. Die dielektrische Schichtenfolge kann dabei insbesondere als Dünnfilmverkapselung ausgeführt sein.

In weiteren Ausführungsbeispielen sind die dielektrische Schichtenfolge und der Wellenlängenkonversionsbereich räumlich getrennt von der organischen Schichtenfolge angeordnet. Beispielsweise sind die dielektrische Schichtenfolge und der Wellenlängenkonversionsbereich über eine Trägerstruktur beabstandet von der organischen Schichtenfolge angeordnet, welche beispielsweise verkapselt ist. Ein Bereich zwischen der organischen Schichtenfolge beziehungsweise der Verkapselung und der dielektrischen Schichtenfolge und dem Wellenlängenkonversionsbereich kann zum Beispiel mit einem Edelgas gefüllt sein.

Bei einer weiteren Ausführungsform weist die dielektrische Schichtenfolge eine periodische Abfolge von ersten und zweiten Schichten auf. Dazu können die Schichten dielektrische Materialien aufweisen, etwa Oxide, Nitride, Sulfide und/oder Fluoride wie zum Beispiel MgF₂. Die ersten Schichten können dabei einen ersten Brechungsindex aufweisen und die zweiten Schichten einen zweiten Brechungsindex, wobei der ersten Brechungsindex vom zweiten Brechungsindex verschieden ist. Beispielsweise können die ersten Schichten einen niedrigeren Brechungsindex aufweisen als die zweiten Schichten und etwa Siliziumdioxid aufweisen. Die zweiten Schichten können weiterhin ein Material mit höherem Brechungsindex aufweisen, etwa Titandioxid, Zirkondioxid oder Tantalpentoxid. Weitere geeignete Materialien können etwa Aluminiumoxid oder Siliziumnitrid sein. Die Dicken der ersten und zweiten Schichten können dabei beispielsweise etwa ein Viertel der Wellenlänge einer zu reflektierenden spektralen Komponente aufweisen. Dazu kann "Dicke" insbesondere die optische Weglänge von elektromagnetischer Strahlung in einer ersten beziehungsweise zweiten Schicht bedeuten. Die Dicken von verschiedenen ersten Schichten beziehungsweise von verschiedenen zweiten Schichten können dabei gleich sein. Alternativ oder zusätzlich können auch Dicken von verschiedenen ersten Schichten beziehungsweise von verschiedenen zweiten Schichten verschieden sein. Je nach zu erzielendem Reflexionsgrad der dielektrischen Schichtenfolge kann diese eine oder mehrere Paare aus einer ersten und einer zweiten Schicht umfassen.

Weiterhin kann die organische Schichtenfolge insbesondere als organische Leuchtdiode (OLED) ausgeführt sein. Eine OLED kann dabei eine organische Schicht oder eine Schichtenfolge mit zumindest einer organischen Schicht aufweisen, mit einem aktiven Bereich, der im Betrieb elektromagnetische Strahlung aussenden kann. Weiterhin kann eine OLED eine erste Elektrode und eine zweite Elektrode aufweisen, wobei die organische Schicht oder die Schichtenfolge mit zumindest einer organischen Schicht mit dem aktiven Bereich zwischen der ersten und zweiten Elektrode angeordnet sein kann. Die erste und die zweite Elektrode können dabei geeignet sein, "Löcher" beziehungsweise Elektronen in den aktiven Bereich zu injizieren, die dort unter Emission von elektromagnetischer Strahlung rekombinieren können.

Weiterhin kann die erste Elektrode auf einem Substrat angeordnet sein. Über der ersten Elektrode kann die organische Schicht oder die Schichtenfolge mit einer oder mehreren funktionalen Schichten aus organischen Materialien aufgebracht sein. Die funktionalen Schichten, die den aktiven Bereich umfassen können, können dabei beispielsweise Elektronentransportschichten, elektro-lumineszierende Schichten und/oder Lochtransportschichten aufweisen. Über den funktionalen Schichten beziehungsweise über der zumindest einen organischen Schicht kann die zweite Elektrode aufgebracht sein.

Beispielsweise kann das Substrat Glas, Quarz, Kunststofffolien, Metall, Metallfolien, Siliziumwafer oder ein beliebiges anderes geeignetes Substratmaterial umfassen. Beispielsweise kann das Substrat auch als Schichtenfolge oder Laminat mehrerer Schichten ausgeführt sein. Ist die Halbleiterschichtenfolge als so genannter "Bottom-Emitter" ausgeführt, das heißt, dass die im aktiven Bereich erzeugte elektromagnetische Strahlung durch das Substrat abgestrahlt werden kann, so kann das Substrat vorteilhafterweise eine Transparenz für zumindest einen Teil der elektromagnetischen Strahlung aufweisen. Der Wellenlängenkonversionsbereich und die Filterschicht können dabei auf einer der Halbleiterschichtenfolge abgewandten Seite des Substrats angeordnet sein.

Gemäß zumindest einer Ausführungsform weist mindestens eine der Elektroden ein transparentes leitendes Oxid, ein Metall oder ein leitendes organisches Material auf oder besteht aus einem solchen.

In der Bottom-Emitter-Konfiguration kann vorteilhafterweise die erste Elektrode transparent für zumindest einen Teil der elektromagnetischen Strahlung sein. Eine transparente erste Elektrode, die als Anode ausgeführt sein kann und somit als positive Ladungen oder "Löcher" injizierendes Material dienen kann, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin müssen die TCOs nicht zwingend einer stöchiometrischen Zusammensetzung entsprechen und können auch p- oder n-dotiert sein. Alternativ oder zusätzlich kann die erste Elektrode auch ein Metall, beispielsweise Silber, aufweisen.

Die Halbleiterschichtenfolge mit zumindest einer organischen Schicht kann Polymere, Oligomere, Monomere, organische kleine Moleküle ("organic small molecules") oder andere organische nichtpolymere Verbindungen oder Kombinationen daraus aufweisen. Insbesondere kann es vorteilhaft sein, wenn eine funktionale Schicht der Schichtenfolge als Lochtransportschicht ausgeführt ist um eine effektive Löcherinjektion in eine elektro-lumineszierende Schicht oder einen elektro-lumineszierenden Bereich zu ermöglichen. Solche Strukturen den aktiven Bereich oder die weiteren funktionalen Schichten und Bereiche betreffend sind dem Fachmann insbesondere hinsichtlich Materialien, Aufbau, Funktion und Struktur bekannt und werden daher an dieser Stelle nicht näher erläutert.

Die zweite Elektrode kann als Kathode ausgeführt sein und somit als Elektronen induzierendes Material dienen. Als Kathodenmaterial können sich unter anderem insbesondere Aluminium, Barium, Indium, Silber, Gold, Magnesium, Calcium oder Lithium sowie Verbindungen, Kombinationen und Legierungen davon als vorteilhaft erweisen. Zusätzlich oder alternativ kann die zweite Elektrode auch transparent ausgeführt sein. Das bedeutet insbesondere, dass die OLED auch als "Top-Emitter" ausgeführt sein kann, das heißt, dass die im aktiven Bereich erzeugte elektromagnetische Strahlung auf der dem Substrat abgewandten Seite der Halbleiterschichtenfolge abgestrahlt werden kann. Der Wellenlängenkonversionsbereich und die Filterschicht können dabei über der Halbleiterschichtenfolge und insbesondere über der zweiten Elektrode angeordnet sein.

Soll eine Elektrode, die die metallische Schicht aufweist oder aus einer solchen besteht, durchlässig für das von dem organischen Schichtstapel ausgesandte Licht ausgebildet sein, so kann es vorteilhaft sein, wenn die metallische Schicht hinreichend dünn ausgebildet ist. Bevorzugt liegt die Dicke einer solchen semitransparenten metallischen Schicht zwischen 1 nm und 100 nm, wobei die Grenzen eingeschlossen sind.

Weiterhin kann die erste Elektrode als Kathode und die zweite Elektrode als Anode ausgeführt sein, wobei die Halbleiterschichtenfolge dabei als Bottom- oder Top-Emitter ausgeführt sein kann. Auch kann die Halbleiterschichtenfolge gleichzeitig als Top-Emitter und als Bottom-Emitter ausgebildet sein.

Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Die Halbleiterschichtenfolge kann neben dem aktiven Bereich weitere funktionelle Schichten und funktionelle Bereiche umfassen, etwa p- oder n-dotierte Ladungsträgertransportschichten, also Elektronen- oder Löchertransportschichten, p- oder n-dotierte Confinement-oder Cladding-Schichten, Pufferschichten und/oder Elektroden sowie Kombinationen daraus. Solche Strukturen den aktiven Bereich oder die weiteren funktionellen Schichten und Bereiche betreffend sind dem Fachmann insbesondere hinsichtlich Aufbau, Funktion und Struktur bekannt und werden von daher an dieser Stelle nicht näher erläutert.

Bei einer weiteren Ausführungsform weist der Wellenlängenkonversionsbereich zumindest einen Wellenlängenkonversionsstoff auf. Gemäß zumindest einer Ausführungsform weist der Wellenlängenkonversionsbereich zumindest einen Wellenlängenkonversionsstoff aus der Gruppe der Granate aufweist. Der Wellenlängenkonversionsstoff kann dabei beispielsweise Partikel aus der Gruppe der Cerdotierten Granate aufweisen, dabei insbesondere Cer-dotiertes Yttriumaluminiumgranat (Y₃Al₅O₁₂:Ce, YAG:Ce), Cer-dotiertes Terbiumaluminiumgranat (TAG:Ce), Cer-dotiertes Terbium-Yttriumaluminiumgranat (TbYAG:Ce), Cer-dotiertes Gadolinium-Yttriumaluminiumgranant (GdYAG:Ce) und Cer-dotiertes Gadolinium-Terbium-Yttriumaluminiumgranat (GdTbYAG:Ce). Weitere mögliche Wellenlängenkonversionsstoffe können beispielsweise folgende sein:
- Granate der seltenen Erden und der Erdalkalimetalle, wie beispielsweise in der Druckschrift US 2004/062699 A1 beschrieben, deren Offenbarungsgehalt diesbezüglich durch Rückbezug aufgenommen wird,
- Nitride, Sione und Sialone, wie beispielsweise in der Druckschrift DE 101 47 040 A1 beschrieben, deren Offenbarungsgehalt diesbezüglich durch Rückbezug aufgenommen wird,
- Orthosilikate, Sulfide, und Vanadate wie beispielsweise in der Druckschrift WO 00/33390 A1 beschrieben, deren Offenbarungsgehalt diesbezüglich durch Rückbezug aufgenommen wird,
- Chlorosilikate, wie beispielsweise in der Druckschrift DE 100 36 940 A1 beschrieben, deren Offenbarungsgehalt diesbezüglich durch Rückbezug aufgenommen wird, und
- Aluminate, Oxide, Halophosphate, wie beispielsweise in der Druckschrift US 6,616,862 B2 beschrieben, deren Offenbarungsgehalt diesbezüglich durch Rückbezug aufgenommen wird.

Weiterhin kann der Wellenlängenkonversionsbereich auch geeignete Mischungen und Kombinationen der genannten Wellenlängenkonversionsstoffe umfassen.

Gemäß zumindest einer Ausführungsform weist der Wellenlängenkonversionsbereich zumindest einen Farbstoff auf. Bei dem Farbstoff kann es sich um zumindest einen der folgenden Stoffe handeln:
- einen organischen Farbstoff,
- einen anorganischen Farbstoff,
- Perylen,
- Kumarin,
- einen fluoreszierenden Farbstoff.

Der Farbstoff kann dabei auch als Wellenlängenkonversionsstoff dienen.

Weiterhin kann der Wellenlängenkonversionsbereich ein transparentes oder zumindest teilweise strahlungsdurchlässiges Matrixmaterial umfassen, wobei der Wellenlängenkonversionsstoff in das Matrixmaterial eingebettet oder daran chemisch gebunden sein kann. Das transparente Matrixmaterial kann beispielsweise einen transparenten Kunststoff aufweisen, etwa Silikone, Epoxide, Acrylate, Imide, Carbonate, Olefine oder Derivate davon.

Der Wellenlängenkonversionsbereich kann auch als Folie ausgeführt sein. Das heißt, der Wellenlängenkonversionsbereich besteht beispielsweise aus einer Kunststofffolie, in die zumindest eine Wellenlängenkonversionsstoff eingebracht ist.

Darüber hinaus kann der Wellenlängenkonversionsbereich auch auf einem Substrat, das etwa Glas oder einen transparenten Kunststoff aufweist, aufgebracht sein. Im Gegensatz zu einer Folie kann ein solches Substrat selbst-tragend sein. Das heißt, es weißt eine erhöhte mechanische Stabilität auf.

Für verschiedene Ausführungsbeispiele der Erfindung, bei denen die organische Schichtenfolge als Top-Emitter-Struktur ausgeführt ist, kann das optoelektronische Bauteil eine Verkapselung aufweisen, die dem Wellenlängenkonversionsbereich im Strahlengang der von der organischen Schichtenfolge abgestrahlten elektromagnetischen Strahlung vorgeordnet oder nachgeordnet ist. Anders ausgedrückt können der Wellenlängenkonversionsbereich und die dielektrische Schichtenfolge gemeinsam mit der organischen Schichtenfolge verkapselt werden oder alternativ außerhalb einer Verkapselung der organischen Schichtenfolge liegen. Die Verkapselung kann jeweils als Dünnschichtverkapselung ausgeführt sein.

Weitere Vorteile und vorteilhafte Ausführungsformen und Weiterbildungen der erfindungsgemäßen Gegenstände ergeben sich aus den im Folgenden in Verbindung mit den Figuren beschriebenen Ausführungsbeispielen.

Es zeigen:
- Figur 1: eine schematische Darstellung eines optoelektronischen Bauteils gemäß einem Ausführungsbeispiel im Betrieb,
- Figur 2: eine schematische Darstellung eines optoelektronischen Bauteils gemäß einem weiteren Ausführungsbeispiel im Betrieb, und
- Figur 3: ein beispielhaftes spektrales Diagramm.

In den Ausführungsbeispielen und Figuren sind gleiche oder gleich wirkende Bestandteile jeweils mit den gleichen Bezugszeichen versehen. Die dargestellten Elemente und deren Größenverhältnisse untereinander sind grundsätzlich nicht als maßstabsgerecht anzusehen, vielmehr können einzelne Elemente, wie zum Beispiel Schichten, zur besseren Darstellbarkeit und/oder zum besseren Verständnis übertrieben dick dargestellt sein.

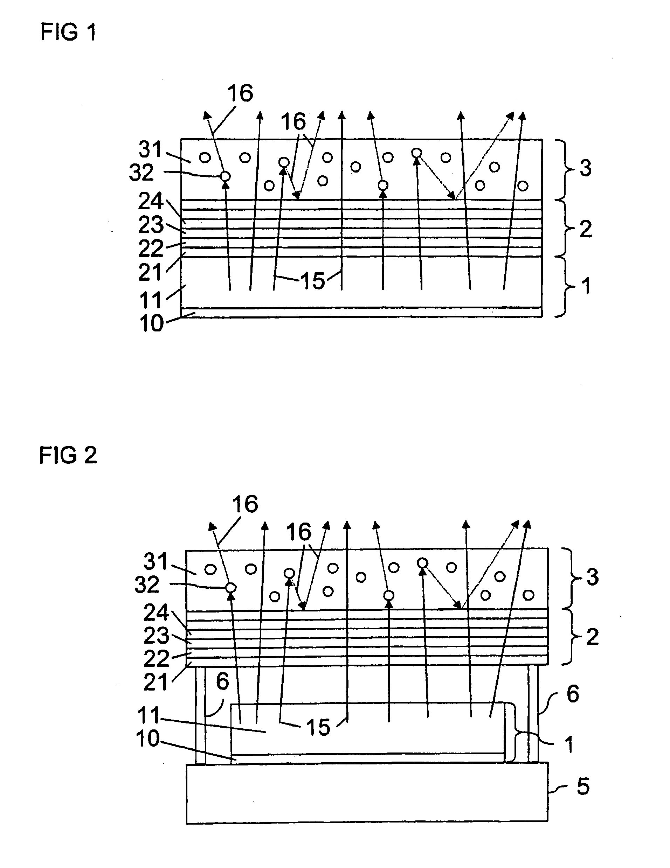

In der Figur 1 ist ein Ausführungsbeispiel für ein optoelektronisches Bauteil gezeigt. Das optoelektronische Bauteil weist eine organische Schichtenfolge 1 mit einer Elektrode 10 und einem aktiven Bereich 11 auf. Die organische Schichtenfolge 1 kann dabei, wie im allgemeinen Teil der Beschreibung ausgeführt, funktionelle Schichten oder Schichtenfolgen aufweisen und ist beispielsweise als OLED ausgeführt. Insbesondere ist der aktive Bereich 11 der organischen Schichtenfolge 1 geeignet, elektromagnetische Strahlung 15 mit einem ersten Wellenlängenspektrum zu emittieren.

Im Strahlengang der elektromagnetischen Strahlung 15 mit dem ersten Wellenlängenspektrum sind eine dielektrische Schichtenfolge 2 und ein Wellenlängenkonversionsbereich 3 angeordnet. Der Wellenlängenkonversionsbereich 3 umfasst einen Wellenlängenkonversionsstoff 32, der, wie in dem Ausführungsbeispiel gezeigt, beispielsweise in ein Matrixmaterial 31 eingebettet ist. Die dielektrische Schichtenfolge 2 umfasst unter anderem Schichten 21, 22, 23, 24, wobei jeweils benachbarte Schichten vorzugsweise aus Materialien mit unterschiedlichen Dielektrizitätskonstanten gebildet sind. Dementsprechend können die Schichten 21 bis 24 auch unterschiedliche Brechungsindices aufweisen.

Der Wellenlängenkonversionsstoff 32 ist dabei geeignet, zumindest teilweise ein Teilspektrum der elektromagnetischen Strahlung 15 mit dem ersten Wellenlängenspektrum in elektromagnetische Strahlung 16 mit einem zweiten Wellenlängenspektrum umzuwandeln. Geeignet für den Wellenlängenkonversionsstoff 32 können hierbei insbesondere Materialien sein, die ein Absorptionsspektrum aufweisen, das zumindest eine spektrale Komponente, insbesondere einen Wellenlängenbereich enthält, der auch in dem ersten Wellenlängenspektrum enthalten ist. Die absorbierte elektromagnetische Strahlung kann dann vorzugsweise mit einer anderen Wellenlänge als die elektromagnetische Strahlung 15 mit dem ersten Wellenlängenspektrum re-emittiert werden.

Durch die besondere Anordnung der einzelnen Schichten 21 bis 24 in der dielektrischen Schichtenfolge 2 ist diese für eine elektromagnetische Strahlung mit einem dritten Wellenlängenspektrum, das zumindest einem Teil des zweiten Wellenlängenspektrums entspricht, undurchlässig. Die elektromagnetische Strahlung 15 mit dem ersten Wellenlängenspektrum, welche bevorzugt im Wesentlichen senkrecht von der organischen Schichtenfolge abgestrahlt wird, kann in diesem Ausführungsbeispiel weitgehend ungehindert und im Wesentlichen ohne Veränderung seiner spektralen Komponenten durch die dielektrische Schichtenfolge 2 hindurch treten. Anders ausgedrückt ist die dielektrische Schichtenfolge 2 für elektromagnetische Strahlung 15 mit dem ersten Wellenlängenspektrum weitgehend transparent. Unter bestimmten Einfallswinkeln kann jedoch die dielektrische Schichtenfolge 2 auch für elektromagnetische Strahlung 15 mit dem ersten Wellenlängenspektrum undurchlässig sein.

Die elektromagnetische Strahlung 16 mit dem zweiten Wellenlängenspektrum, die aus dem Wellenlängenkonversionsbereich 3 isotrop abgestrahlt wird, tritt also teilweise zusammen mit der elektromagnetischen Strahlung 15 mit dem ersten Wellenlängenspektrum aus dem optoelektronischen Bauteil aus. Ein Teil der Strahlung 16 wird jedoch in Richtung der dielektrischen Schichtenfolge 2 emittiert, wobei dieser Teil jedoch die dielektrische Schichtenfolge 2 nicht durchdringen kann, sondern reflektiert wird. Im Betrieb des optoelektronischen Bauteils wird demzufolge eine Kombination von elektromagnetischer Strahlung mit dem ersten Wellenlängenspektrum und elektromagnetischer Strahlung 16 mit dem zweiten Wellenlängenspektrum abgegeben. Bei einem Betrachter des optoelektronischen Bauteils kann somit ein Farbeindruck erweckt werden, welcher aus einer Überlagerung des ersten und zweiten Wellenlängenspektrums resultiert. Beispielsweise umfasst das erste Wellenlängenspektrum einen blauen Wellenlängenbereich und das zweite Wellenlängenspektrum einen gelben Wellenlängebereich, so dass in diesem Fall für einen Betrachter ein weißer Farbeindruck entsteht.

Da in dem vorliegenden Ausführungsbeispiel keine konvertierte elektromagnetische Strahlung 16 zurück in die organische Schichtenfolge 1 gestrahlt werden kann, sondern an der dielektrischen Schichtenfolge 2 reflektiert wird, kann eine teilweise Absorption bereits konvertierter Strahlung 16 in der organischen Schichtenfolge 1 vermieden werden. Die Effizienz des optoelektronischen Bauteils ist dadurch erhöht.

Durch die materielle Beschaffenheit der Schichten der dielektrischen Schichtenfolge 2 ist diese wenigstens teilweise undurchlässig für elektromagnetische Strahlung mit einem dritten Wellenlängenspektrum, das zumindest einem Teil des zweiten Wellenlängenspektrums entspricht. Vorzugsweise ist die dielektrische Schichtenfolge 2 nahezu vollständig undurchlässig für elektromagnetische Strahlung mit dem zweiten Wellenlängenspektrum beziehungsweise dem dritten Wellenlängenspektrum. Beispielsweise weisen hierfür benachbarte Schichten, zum Beispiel die Schichten 21, 22 unterschiedliche Brechungsindices auf. Durch den Brechungsindexsprung kann elektromagnetische Strahlung beziehungsweise Licht einer bestimmten Wellenlänge nicht durch die Schichtenfolge 2 durchdringen.

In einem Ausführungsbeispiel weist die dielektrische Schichtenfolge 2 eine periodische Abfolge von ersten Schichten 21, 23 und zweiten Schichten, 22, 24 auf, wobei die ersten Schichten einen ersten Brechungsindex aufweisen und die zweiten Schichten einen vom ersten Brechungsindex verschiedenen zweiten Brechungsindex aufweisen. Die ersten und zweiten Schichten können dabei jeweils eine gleiche Schichtdicke aufweisen. Alternativ können die ersten Schichten 21, 23 sowie die zweiten Schichten 22, 24 jeweils unterschiedliche Brechungsindices aufweisen, so dass beispielsweise jede der Schichten der dielektrischen Schichtenfolge 2 einen anderen Brechungsindex aufweist. Dabei sollten sich jedoch höhere und niedrigere Brechungsindices in den Schichten einander abwechseln. Alternativ oder zusätzlich können auch die Schichtdicken der Schichten 21 bis 24 beliebig unterschiedlich sein. Auch eine Anzahl der Schichten der dielektrischen Schichtenfolge 2 ist nicht auf die hier in diesem Ausführungsbeispiel gezeigte Anzahl von sechs Schichten beschränkt, sondern kann auch höher oder niedriger sein. Beispielsweise weist die dielektrische Schichtenfolge eine Anzahl von acht oder mehr Schichten auf.

Die dielektrische Schichtenfolge 2 kann eine Grenzwellenlänge aufweisen, wobei die dielektrische Schichtenfolge 2 für elektromagnetische Strahlung mit einer Wellenlänge kleiner als die Grenzwellenlänge im Wesentlichen durchlässig und für elektromagnetische Strahlung mit einer Wellenlänge größer als die Grenzwellenlänge im Wesentlichen undurchlässig ist. Die Grenzwellenlänge kann dabei beispielsweise von einer jeweiligen Schichtdicke und/oder jeweiligen Brechungsindices der Schichten der dielektrischen Schichtenfolge 2 abhängen.

In diesem Ausführungsbeispiel stehen die dielektrische Schichtenfolge 2 und der Wellenlängenkonversionsbereich 3 in mittelbarem beziehungsweise unmittelbarem Kontakt mit der organischen Schichtenfolge 1. Anders ausgedrückt bilden die organische Schichtenfolge 1, die dielektrische Schichtenfolge 2 und der Wellenlängenkonversionsbereich 3 eine gemeinsame miteinander verbundene Struktur. Eine Wellenlängenkonversion mit einem optoelektronischen Bauteil gemäß diesem Ausführungsbeispiel kann auch als Konversion auf Chipebene, chip level conversion, CLC bezeichnet werden.

In dem Ausführungsbeispiel gemäß der Figur 2 wird ein optoelektronisches Bauteil beschrieben, dessen prinzipielle Funktionsweise der des Ausführungsbeispiels gemäß der Figur 1 entspricht. Jedoch ist in diesem Ausführungsbeispiel die organische Schichtenfolge 1 räumlich getrennt von der dielektrischen Schichtenfolge 2 und dem Wellenlängenkonversionsbereich 3 angeordnet. Dazu ist die organische Schichtenfolge 1 auf ein Trägersubstrat 5 aufgebracht und beispielsweise auf diesem verkapselt (nicht gezeigt). Ferner sind Halteelemente 6 vorgesehen, welche eine mechanische Halterung zur Beabstandung der dielektrischen Schichtenfolge 2 und des Wellenlängenkonversionsbereichs 3 darstellen. Die Halterung schließt beispielsweise einen Raum, in dem die organische Schichtenfolge 1 angeordnet ist, luftdicht beziehungsweise gasdicht ab. Beispielsweise ist der so gebildete Raum zwischen der dielektrischen Schichtenfolge 2 und der organischen Schichtenfolge 1 mit einem transparenten gasförmigen Stoff, vorzugsweise einem Edelgas gefüllt.

Wie zuvor für das Ausführungsbeispiel in Figur 1 beschrieben, wird von der organischen Schichtenfolge 1 elektromagnetische Strahlung 15 mit dem ersten Wellenlängenspektrum emittiert, tritt durch die dielektrische Schichtenfolge 2 durch und wird im Wellenlängenkonversionsbereich 3 zumindest teilweise in elektromagnetische Strahlung 16 mit dem zweiten Wellenlängenspektrum konvertiert. Wiederum wird eine Rückstrahlung bereits konvertierter elektromagnetischer Strahlung 16 in die organische Schichtenfolge 1 durch die dielektrische Schichtenfolge 2 verhindert.

Da in diesem Ausführungsbeispiel der Wellenlängenkonversionsbereich 3 beabstandet zur strahlungsemittierenden organischen Schichtenfolge 1 angeordnet ist, wird auch von einer "Remote Phosphor"-Anordnung gesprochen.

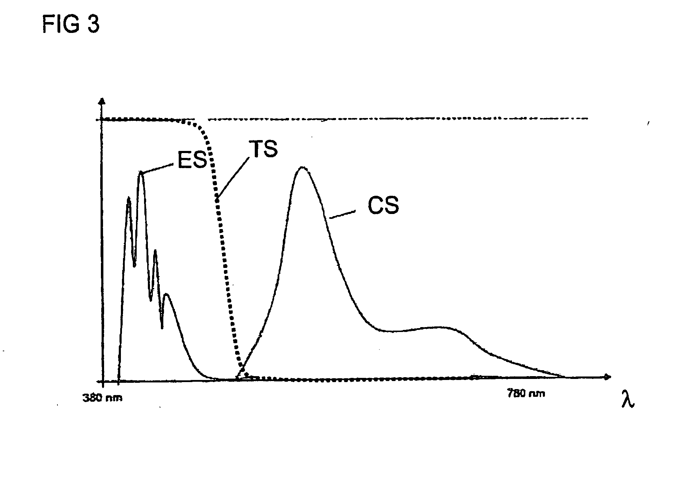

Figur 3 zeigt ein beispielhaftes spektrales Diagramm mit verschiedenen Transmissionscharakteristiken beziehungsweise Emissionscharakteristiken in Abhängigkeit einer Wellenlänge λ. Eine Emissionscharakteristik beziehungsweise ein Emissionsspektrum ES stellt beispielsweise einen spektralen Verlauf der elektromagnetischen Strahlung 15, die von der organischen Schichtenfolge 1 abgestrahlt wird, dar. Das Emissionsspektrum ES umfasst dabei einen blauen Wellenlängenbereich. Ein Konversionsspektrum CS stellt das vom Wellenlängenkonversionsbereich 3 emittierte Wellenlängenspektrum dar, das beispielsweise der elektromagnetischen Strahlung 16 zugrunde liegt. Das Konversionsspektrum CS umfasst demnach einen gelben Wellenlängenbereich beziehungsweise einen rot-grünen Wellenlängenbereich. Die mit TS bezeichnete Kurve gibt ein Transmissionsspektrum der dielektrischen Schichtenfolge 2 an. Dementsprechend ist die dielektrische Schichtenfolge 2 für blaues Licht und damit für die von der organischen Schichtenfolge 1 abgestrahlte elektromagnetische Strahlung 15 durchlässig, während sie für elektromagnetische Strahlung mit einem gelben Wellenlängenbereich beziehungsweise einem roten und grünen Wellenlängenbereich undurchlässig ist. Konvertierte elektromagnetische Strahlung 16 kann daher nicht durch die dielektrische Schichtenfolge 2 hindurch treten.

Eine Transmissionscharakteristik TS und insbesondere eine Transparenz der dielektrischen Schichtenfolge 2 kann zusätzlich auch von einem Einfallswinkel der jeweiligen elektromagnetischen Strahlung abhängen. Eine Grenzwellenlänge, ab der eine dielektrische Schichtenfolge gemäß einem der beschriebenen Ausführungsbeispiele reflektiert, hängt von einem Einfallswinkel der elektromagnetischen Strahlung beziehungsweise des Lichts ab. Die für einen Einfallswinkel von Null Grad definierte Grenzwellenlänge verschiebt sich für größere Winkel zu kürzeren Wellenlängen. Damit erlaubt eine derartige dielektrische Filterschicht eine Ausrichtung der Abstrahlcharakteristik des optoelektronischen Bauelements.

Senkrecht emittiertes blaues beziehungsweise blau-grünes Licht der organischen Schichtenfolge kann die dielektrische Schichtenfolge ungehindert passieren. Wenn jedoch blaues beziehungsweise blau-grünes Licht auf die organische Schichtenfolge zurückgestreut wird, kann dieses Licht die dielektrische Filterschicht jedoch nur bei Einfall im gewählten Winkelbereich passieren. Dementsprechend wird blaues beziehungsweise blau-grünes Licht, welches unter einem größeren Winkel in Richtung der organischen Schichtenfolge zurückgestreut wird von der dielektrischen Schichtenfolge 2 zurück in den Wellenlängenkonversionsbereich 3 reflektiert. Somit wird zusätzlich Absorption von zurückgestreutem blauen beziehungsweise blau-grünem Licht verringert. Das längerwellige, konvertierte Licht aus dem Wellenlängenkonversionsbereich 3 kann die organische Schichtenfolge 1, aufgrund der Transmissionscharakteristik der dielektrischen Schichtenfolge 2, unter keinem Einfallswinkel erreichen. Eine winkelabhängige Transmission beziehungsweise Reflexion von zumindest Teilen der elektromagnetischen Strahlung mit dem ersten Wellenlängenspektrum erhöht somit weiter die Effizienz des optoelektronischen Bauteils.

Ein optoelektronisches Bauteil gemäß einem der dargestellten Ausführungsbeispiele kann beispielsweise als Komponente für ein Blitzlicht, für eine Mobiltelefonanwendung mit Kamera geeignet sein. Weiterhin kann ein solches optoelektronisches Bauteil auch für Beleuchtungseinrichtungen zum Beispiel zur Allgemeinbeleuchtung geeignet sein.

## Patentansprüche

1. Optoelektronisches Bauteil, umfassend
- eine organische Schichtenfolge (1), die im Betrieb eine elektromagnetische Strahlung (15) mit einem ersten Wellenlängenspektrum abstrahlt;
- ein Trägersubstrat (5), auf das die organische Schichtenfolge (1) aufgebracht ist,
- einen Wellenlängenkonversionsbereich (3) im Strahlengang der von der organischen Schichtenfolge (1) abgestrahlten elektromagnetischen Strahlung (15), der eingerichtet ist, zumindest teilweise elektromagnetische Strahlung mit dem ersten Wellenlängenspektrum in eine elektromagnetische Strahlung (16) mit einem zweiten Wellenlängenspektrum umzuwandeln; und
- eine Schichtenfolge (2), die im Strahlengang der von der organischen Schichtenfolge (1) abgestrahlten elektromagnetischen Strahlung (15) zwischen der organischen Schichtenfolge (1) und dem Wellenlängenkonversionsbereich (3) angeordnet ist und die für eine elektromagnetische Strahlung mit einem dritten Wellenlängenspektrum, das zumindest einem Teil des zweiten Wellenlängenspektrums entspricht, wenigstens teilweise undurchlässig ist, **dadurch gekennzeichnet, dass**
- die Schichtenfolge eine dielektrische Schichtenfolge ist,
- die dielektrische Schichtenfolge (2) eine Verkapselung für die organische Schichtenfolge (1) bildet,
- die dielektrische Schichtenfolge (2) die organische Schichtenfolge (1) auf den Teilen ihrer Oberfläche, die nicht vom Trägersubstrat (5) bedeckt sind, bedeckt, und
- die dielektrische Schichtenfolge (2) einen Schutz der organischen Schichtenfolge (1) vor Feuchtigkeit und atmosphärischen Gasen bildet.

2. Optoelektronisches Bauteil nach Anspruch 1,
bei dem die dielektrische Schichtenfolge (2) für die elektromagnetische Strahlung (15) mit dem ersten Wellenlängenspektrum zumindest teilweise transparent ist.

3. Optoelektronisches Bauteil nach Anspruch 2,
bei dem eine Transparenz der dielektrischen Schichtenfolge (2) für die elektromagnetische Strahlung (15) mit dem ersten Wellenlängenspektrum von einem jeweiligen Einfallswinkel abhängig ist.

4. Optoelektronisches Bauteil nach einem der Ansprüche 1 bis 3,
bei dem das erste Wellenlängenspektrum einen blauen und/oder einen grünen Wellenlängenbereich umfasst und das zweite Wellenlängenspektrum einen gelben Wellenlängenbereich umfasst.

5. Optoelektronisches Bauteil nach einem der Ansprüche 1 bis 4,
bei dem die dielektrische Schichtenfolge (2) die elektromagnetische Strahlung (15) mit dem dritten Wellenlängenspektrum zumindest überwiegend reflektiert.

6. Optoelektronisches Bauteil nach einem der Ansprüche 1 bis 5,
bei dem die dielektrische Schichtenfolge (2) wenigstens zwei Schichten (21, 22, 23, 24) mit unterschiedlicher Dielektrizitätskonstante aufweist.

7. Optoelektronisches Bauteil nach Anspruch 6,
bei dem benachbarte Schichten der wenigstens zwei Schichten (21, 22, 23, 24) der dielektrischen Schichtenfolge (2) unterschiedliche Brechungsindices aufweisen.

8. Optoelektronisches Bauteil nach einem der Ansprüche 1 bis 7,
bei dem die dielektrische Schichtenfolge (2) eine periodische Abfolge von ersten Schichten (21, 23) und zweiten Schichten (22, 24) aufweist und die ersten Schichten (21, 23) einen ersten Brechungsindex aufweisen und die zweiten Schichten (22, 24) einen vom ersten Brechungsindex verschiedenen zweiten Brechungsindex aufweisen.

9. Optoelektronisches Bauteil nach einem der Ansprüche 1 bis 8,
bei dem die dielektrische Schichtenfolge (2) eine Grenzwellenlänge aufweist, wobei die dielektrische Schichtenfolge (2) für elektromagnetische Strahlung mit einer Wellenlänge kleiner als die Grenzwellenlänge im Wesentlichen durchlässig und für elektromagnetische Strahlung mit einer Wellenlänge größer als die Grenzwellenlänge im Wesentlichen undurchlässig ist.

10. Optoelektronisches Bauteil nach einem der Ansprüche 1 bis 9,
bei dem die dielektrische Schichtenfolge (2) als Dünnschichtstapel ausgeführt ist.

11. Optoelektronisches Bauteil nach einem der Ansprüche 1 bis 10,
bei dem die dielektrische Schichtenfolge (2) und der Wellenlängenkonversionsbereich (3) in mittelbarem oder unmittelbarem Kontakt mit der organischen Schichtenfolge (1) stehen.

12. Optoelektronisches Bauteil nach dem vorherigen Anspruch, bei dem die dielektrische Schichtenfolge (2) im direkten Kontakt zur organischen Schichtenfolge (1) und zum Wellenlängenkonversionsbereich (3) steht.

13. Optoelektronisches Bauteil nach Anspruch 1,
bei dem die Verkapselung als Dünnschichtverkapselung ausgeführt ist.

## Claims

1. Optoelectronic component, comprising
- an organic layer sequence (1), which emits an electromagnetic radiation (15) having a first wavelength spectrum during operation;
- a carrier substrate (5), to which the organic layer sequence (1) is applied,
- a wavelength conversion region (3) in the beam path of the electromagnetic radiation (15) emitted by the organic layer sequence (1), said wavelength conversion region being designed to convert at least partly electromagnetic radiation having the first wavelength spectrum into an electromagnetic radiation (16) having a second wavelength spectrum; and
- a layer sequence (2), which is arranged in the beam path of the electromagnetic radiation (15) emitted by the organic layer sequence (1) between the organic layer sequence (1) and the wavelength conversion region (3) and which is at least partly non-transmissive for an electromagnetic radiation having a third wavelength spectrum, which corresponds to at least part of the second wavelength spectrum, **characterized in that**
- the layer sequence is a dielectric layer sequence,
- the dielectric layer sequence (2) forms an encapsulation for the organic layer sequence (1),
- the dielectric layer sequence (2) covers the organic layer sequence (1) on those parts of its surface which are not covered by the carrier substrate (5), and
- the dielectric layer sequence (2) forms a protection of the organic layer sequence (1) against moisture and atmospheric gases.

2. Optoelectronic component according to Claim 1, wherein the dielectric layer sequence (2) is at least partly transparent for the electromagnetic radiation (15) having the first wavelength spectrum.

3. Optoelectronic component according to Claim 2, wherein a transparency of the dielectric layer sequence (2) for the electromagnetic radiation (15) having the first wavelength spectrum is dependent on a respective angle of incidence.

4. Optoelectronic component according to any of Claims 1 to 3,
wherein the first wavelength spectrum comprises a blue and/or a green wavelength range, and the second wavelength spectrum comprises a yellow wavelength range.

5. Optoelectronic component according to any of Claims 1 to 4,
wherein the dielectric layer sequence (2) at least predominantly reflects the electromagnetic radiation (15) having the third wavelength spectrum.

6. Optoelectronic component according to any of Claims 1 to 5,
wherein the dielectric layer sequence (2) comprises at least two layers (21, 22, 23, 24) having different dielectric constants.

7. Optoelectronic component according to Claim 6, wherein adjacent layers of the at least two layers (21, 22, 23, 24) of the dielectric layer sequence (2) have different refractive indices.

8. Optoelectronic component according to any of Claims 1 to 7,
wherein the dielectric layer sequence (2) comprises a periodic succession of first layers (21, 23) and second layers (22, 24), and the first layers (21, 23) have a first refractive index, and the second layers (22, 24) have a second refractive index, which is different from the first refractive index.

9. Optoelectronic component according to any of Claims 1 to 8,
wherein the dielectric layer sequence (2) has a limiting wavelength, wherein the dielectric layer sequence (2) is substantially transmissive for electromagnetic radiation having a wavelength less than the limiting wavelength and is substantially non-transmissive for electromagnetic radiation having a wavelength greater than the limiting wavelength.

10. Optoelectronic component according to any of Claims 1 to 9,
wherein the dielectric layer sequence (2) is embodied as a thin-film stack.

11. Optoelectronic component according to any of Claims 1 to 10,
wherein the dielectric layer sequence (2) and the wavelength conversion region (3) are in indirect or direct contact with the organic layer sequence (1).

12. Optoelectronic component according to the preceding claim,
wherein the dielectric layer sequence (2) is in direct contact with the organic layer sequence (1) and with the wavelength conversion region (3).

13. Optoelectronic component according to Claim 1, wherein the encapsulation is embodied as a thin-film encapsulation.

## Revendications

1. Composant optoélectronique comportant :
une succession (1) de couches organiques qui, en fonctionnement, émet un rayonnement électromagnétique (15) qui présente un premier spectre de longueurs d'onde,
un substrat de support (5) sur lequel la succession (1) de couches organiques est appliquée,
une zone (3) de conversion de longueurs d'onde disposée dans le chemin du rayonnement électromagnétique (15) émis par la succession (1) de couches organiques et conçu pour convertir au moins une partie du rayonnement électromagnétique qui présente le premier spectre de longueurs d'onde en un rayonnement électromagnétique (16) qui présente un deuxième spectre de longueurs d'onde et
une succession (2) de couches qui est disposée dans le chemin du rayonnement électromagnétique (15) émis par la succession (1) de couches organiques entre la succession (1) de couches organiques et la zone (3) de conversion de longueurs d'onde et qui est au moins partiellement opaque vis-à-vis d'un rayonnement électromagnétique qui présente un troisième spectre de longueurs d'onde qui correspond à au moins une partie du deuxième spectre de longueurs d'onde,
**caractérisé en ce que**
la succession de couches est une succession de couches diélectriques,
**en ce que** la succession (2) de couches diélectriques forme une encapsulation de la succession (1) de couches organiques,
**en ce que** la succession (2) de couches diélectriques recouvre la succession (1) de couches organiques sur les parties de sa surface non couvertes par le substrat de support (5) et
**en ce que** la succession (2) de couches diélectriques forme une protection de la succession (1) de couches organiques vis-à-vis de l'humidité et des gaz atmosphériques.

2. Composant optoélectronique selon la revendication 1, dans lequel la succession (2) de couches diélectriques est au moins partiellement transparente vis-à-vis du rayonnement électromagnétique (15) qui présente le premier spectre de longueurs d'onde.

3. Composant optoélectronique selon la revendication 2, dans lequel la transparence de la succession (2) de couches diélectriques vis-à-vis du rayonnement électromagnétique (15) qui présente le premier spectre de longueurs d'onde dépend de l'angle d'incidence particulier.

4. Composant optoélectronique selon l'une des revendications 1 à 3, dans lequel le premier spectre de longueurs d'onde comporte la plage bleue et/ou la plage verte des longueurs d'onde et en ce que le deuxième spectre de longueurs d'onde comporte la plage jaune des longueurs d'onde.

5. Composant optoélectronique selon l'une des revendications 1 à 4, dans lequel la succession (2) de couches diélectriques réfléchit au moins de manière prédominante le rayonnement électromagnétique (15) qui présente le troisième spectre de longueurs d'onde.

6. Composant optoélectronique selon l'une des revendications 1 à 5, dans lequel la succession (2) de couches diélectriques présente au moins deux couches (21, 22, 23, 24) qui présentent différentes constantes diélectriques.

7. Composant optoélectronique selon la revendication 6, dans lequel des couches voisines des au moins deux couches (21, 22, 23, 24) de la succession (2) de couches diélectriques présentent différents indices de réfraction.

8. Composant optoélectronique selon l'une des revendications 1 à 7, dans lequel la succession (2) de couches diélectriques présente une succession périodique de premières couches (21, 23) et de deuxièmes couches (22, 24) et en ce que les premières couches (21, 23) présentent un premier indice de réfraction et les deuxièmes couches (22, 24) un deuxième indice de réfraction différent du premier indice de réfraction.

9. Composant optoélectronique selon l'une des revendications 1 à 8, dans lequel la succession (2) de couches diélectriques présente une longueur d'onde limite, la succession (2) de couches diélectriques étant essentiellement transparente vis-à-vis d'un rayonnement électromagnétique qui présente une longueur d'onde inférieure à la longueur d'onde limite et est essentiellement opaque vis-à-vis du rayonnement électromagnétique qui présente une longueur d'onde supérieure à la longueur d'onde limite.

10. Composant optoélectronique selon l'une des revendications 1 à 9, dans lequel la succession (2) de couches diélectriques est réalisée sous la forme d'un empilement de couches minces.

11. Composant optoélectronique selon l'une des revendications 1 à 10, dans lequel la succession (2) de couches diélectriques et la zone (3) de conversion de longueurs d'onde sont en contact direct ou indirect avec la succession (1) de couches organiques.

12. Composant optoélectronique selon la revendication précédente, dans lequel la succession (2) de couches diélectriques est en contact direct avec la succession (1) de couches organiques et avec la zone (3) de conversion de longueurs d'onde.

13. Composant optoélectronique selon la revendication 1, dans lequel l'encapsulation est configurée comme encapsulation en couche mince.
